# EUROPEAN PATENT APPLICATION

(11) **EP 1 098 203 A2**
(43) Date of publication of application: **09.05.2001**
(21) Application number: 00123750.2
(22) Date of filing: 31.10.2000
(51) Int. Cl.: G01R 33/09, G11B 5/39

(54) **Magnetic tunnel junction element, tunneling magnetoresistive head, and production methods**

(30) Priority: 04.11.1999 JP 31429199
(71) Applicant: SONY CORPORATION, Tokyo (JP)
(72) Inventor: Sugawara, Junichi, Shinagawa-ku, Tokyo (JP); Nakashio, Eiji, Shinagawa-ku, Tokyo (JP); Kumagai, Seiji, Shinagawa-ku, Tokyo (JP)
(74) Representative: MÜLLER & HOFFMANN Patentanwälte

(57) **Abstract**

The present invention suppresses generation of the Barkhausen noise by providing a magnetic tunnel junction element including: a first magnetic layer having magnetization fixed in a predetermined direction, an insulation layer formed on the first magnetic layer, and a second magnetic layer formed on the insulation layer and changing its magnetization direction according to an external magnetic field, wherein the second magnetic layer is provided with non-conducting magnetic domain control films formed at both end portions on the second magnetic layer.

## Description

### Background of the Invention

### Field of the Invention

The present invention relates to a magnetic tunnel junction element including a pair of magnetic layers formed via an insulation layer in which conductance of tunnel current flowing from one of the magnetic layers to the other magnetic layer varies depending on a relative angle of magnetization of the pair of magnetic layers and a production method of the magnetic tunnel junction element. Moreover, the present invention relates to a tunneling magnetoresistive head having such a magnetic tunnel junction element and a production method thereof.

### Description of the Prior Art

A so-called magnetic tunnel effect has been reported conventionally. In a layered configuration having a thin insulation layer sandwiched by a pair of magnetic layers, when a predetermined voltage is applied between the magnetic layers, a so-called tunnel current flows via the insulation layer and the conductance of the tunnel current varies depending on a relative angle of magnetization of the pair of magnetic layers. That is, in a layered configuration having a thin insulation layer sandwiched by a pair of magnetic layers, the magnetoresistive effect is observed against the tunnel current flowing in the insulation layer.

In this magnetic tunnel effect, the magnetoresistance ratio can be theoretically calculated from the polarization ratio of the magnetization of the pair of magnetic layers. Especially, when Fe is employed as the material of the pair of the magnetic layers, a magnetoresistance ratio of about 40 % can be expected.

For this, a magnetic tunnel junction element having a layered configuration of a thin insulation layer sandwiched by a pair of magnetic layers is now gathering attention as a magnetoresistive element. Special attention is now paid in the field of magnetic heads, on a so-called tunneling magnetoresistive head (hereinafter, referred to as a TMR head) in which the magnetic tunnel junction element is used as a magnet sensitive element for detecting a magnetic signal from a magnetic recording medium.

In the aforementioned TMR head, like the magnetoresistive head (hereinafter, referred to as an MR head), a magnetic domain control is required for suppressing the Barkhausen noise. Generally, in the MR head, in order suppress this Barkhausen noise, a pair of bias layers are provided so as to be connected electrically and magnetically to the both sides of the magnetoresistive element.

However, in the case of TMR head, a tunnel current flows from one of the magnetic layers to the other magnetic layer in the pair of magnetic layers formed via an insulation layer. Accordingly, when the aforementioned bias layer is provided on both sides of the magnetic tunnel junction element, an electrical short circuit results in the side portions of the magnetic tunnel junction elements where the bias layers are arranged. For this, it is impossible this method.

### Summary of the Invention

It is therefore an object of the present invention to provide a magnetic tunnel junction element capable of suppressing the Barkhausen noise and stabilize the reproduction output and a production method thereof as well as a tunneling magnetoresistive head including such a magnetic tunnel junction element and a production method thereof.

In order to achieve the aforementioned object, the magnetic tunnel junction element according to the present invention includes: a first magnetic layer having magnetization fixed in a predetermined direction, an insulation layer formed on the first magnetic layer, and a second magnetic layer formed on the insulation layer and changing its magnetization direction according to an external magnetic field, wherein the second magnetic layer is provided with non-conducting magnetic domain control films formed at both end portions on the second magnetic layer.

As has been described above, in the magnetic tunnel junction element according to the present invention, non-conducting magnetic domain control films are formed at both end portions of the second magnetic layers. Accordingly, it is possible to perform magnetic domain control of the second magnetic layer without causing any electric short circuit and to suppress generation of Barkhausen noise.

Moreover, the magnetic tunnel junction element production method includes steps of: forming a first magnetic layer having its magnetization direction fixed in a predetermined direction, forming an insulation layer on the first magnetic layer, forming a second magnetic layer on the insulation layer so as to change its magnetization direction according to an external magnetic field, forming a non-conducting magnetic domain control film on the second magnetic layer, forming a resist pattern having a predetermined configuration on the magnetic domain control film, and removing the magnetic domain control film by etching using the resist pattern excluding the both end portions on the second magnetic layer.

As has been described above, in the magnetic tunnel junction element production method according to the present invention, it is possible to successively form at least first magnetic layer, an insulation layer, a second magnetic layer, and a magnetic domain control film in this order in a single apparatus.

Moreover, the tunneling magnetoresistive head includes a first magnetic layer having magnetization fixed in a predetermined direction, an insulation layer formed on the first magnetic layer, a second magnetic layer formed on the insulation layer and changing its magnetization direction according to an external magnetic field, wherein the second magnetic layer is provided with non-conducting magnetic domain control films on both end portions thereof.

As has been described above, in the tunneling magnetoresistive head according to the present invention, non-conducting magnetic domain control films are formed on both end portions on the second magnetic layer of the magnetic tunnel junction element. Accordingly, it is possible to perform the magnetic domain control of the second magnetic layer without causing any electric short circuit and to suppress Barkhausen noise.

Moreover, the tunneling magnetoresistive head production method according to the present invention including a magnetic tunnel junction element is produced by steps of: forming a first magnetic layer having its magnetization direction fixed in a predetermined direction, forming an insulation layer on the first magnetic layer, forming a second magnetic layer on the insulation layer so as to change its magnetization direction according to an external magnetic field, forming a non-conducting magnetic domain control film on the second magnetic layer, forming a resist pattern having a predetermined configuration on the magnetic domain control film, and removing the magnetic domain control film by etching using the resist pattern excluding the both end portions on the second magnetic layer.

As has been described above, in the tunneling magnetoresistive head production method according to the present invention, it is possible to successively form at least the first magnetic layer, the insulation layer, the second magnetic layer, and the magnetic domain control film in this order in a single apparatus so as to constitute the magnetic tunnel junction element.

### Brief Description of the Drawings

Fig. 1 is a brief perspective view showing a configuration example of a magnetic tunnel junction element according to the present invention.
Fig. 2 is a brief enlarged perspective view of an essential portion of the tunnel junction element.
Fig. 3 is a brief perspective view showing a configuration example of a tunneling magnetoresistive head according to the present invention.
Fig. 4 is a brief cross sectional view showing a production step of the tunneling magnetoresistive head, wherein a magnetic metal film serving as a lower shield layer and a non-magnetic metal film serving as a lower gap layer are successively formed on a substrate.
Fig. 5 is a brief cross sectional view showing a production step of the tunneling magnetoresistive head, wherein the non-magnetic metal film is successively coated with an IrMn film and a CoFe film serving as a first magnetic metal layer and an Al₂O₃ film serving as a tunnel barrier layer.
Fig. 6 is a brief cross sectional view showing a production step of the tunneling magnetoresistive head, wherein the Al₂O₃ film is successively coated with a CoFe film and a NiFe film serving as a second magnetic metal layer and a NiO film serving as a magnetic domain control film.
Fig. 7 is a brief cross sectional view showing a production step of the tunneling magnetoresistive head, wherein a resist pattern of a predetermined configuration is formed on the NiO film.
Fig. 8 is a brief cross sectional view showing a production step of the tunneling magnetoresistive head, wherein the resist pattern is used as a mask for etching the NiO film into a predetermined configuration.
Fig. 9 is a brief cross sectional view showing a production step of the tunneling magnetoresistive head, wherein with the resist pattern remaining, a non-magnetic metal film 40 serving as an upper gap layer is formed.
Fig. 10 is a brief cross sectional view showing a production step of the tunneling magnetoresistive head, wherein the resist pattern and the non-magnetic metal film remaining on the resist pattern are removed.
Fig. 11 is a brief cross sectional view showing a production step of the tunneling magnetoresistive head, wherein a resist pattern of a predetermined configuration is formed on the upper gap layer 24 and the NiO film.
Fig. 12 is a brief cross sectional view showing a production step of the tunneling magnetoresistive head, wherein the resist pattern is used as a mask for etching the NiO film into a predetermined configuration.
Fig. 13 is a brief cross sectional view showing a production step of the tunneling magnetoresistive head, wherein with the resist pattern remaining, an insulation film is formed.
Fig. 14 is a brief cross sectional view showing a production step of the tunneling magnetoresistive head, wherein the resist pattern and the insulation film remaining on the resist pattern are removed.
Fig. 15 is a brief cross sectional view showing a production step of the tunneling magnetoresistive head, wherein an upper shield layer of a predetermined configuration is formed on the main surface from which the resist pattern has been removed.

### Detailed Description of Preferred Embodiments

Description will now be directed to preferred embodiments of the present invention with reference to the attached drawings.

It should be noted that in the drawings used in the explanation below, essential portions are sometimes enlarged and the dimensional ratio of the components may not be identical to the actual ratio.

Firstly, explanation will be given on the magnetic tunnel junction element according to the present invention.

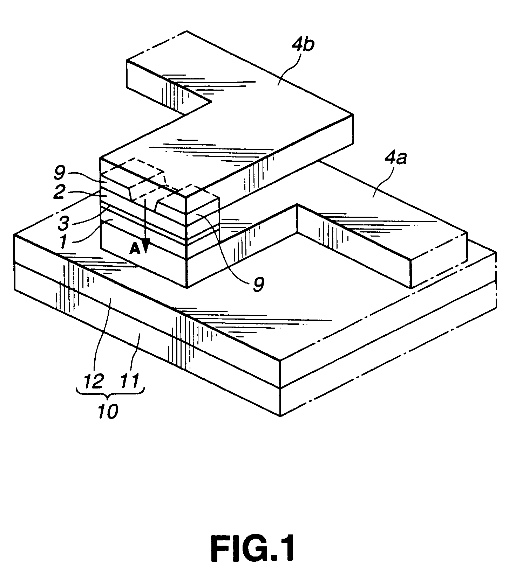

As shown in Fig. 1, the magnetic tunnel junction element has a layered configuration of a first magnetic metal layer 1 and a second magnetic metal layer 2 which are layered via a tunnel barrier layer 3. A first electrode 4a and a second electrode 4b are connected to the first magnetic metal layer 1 and the second magnetic metal layer 2, respectively.

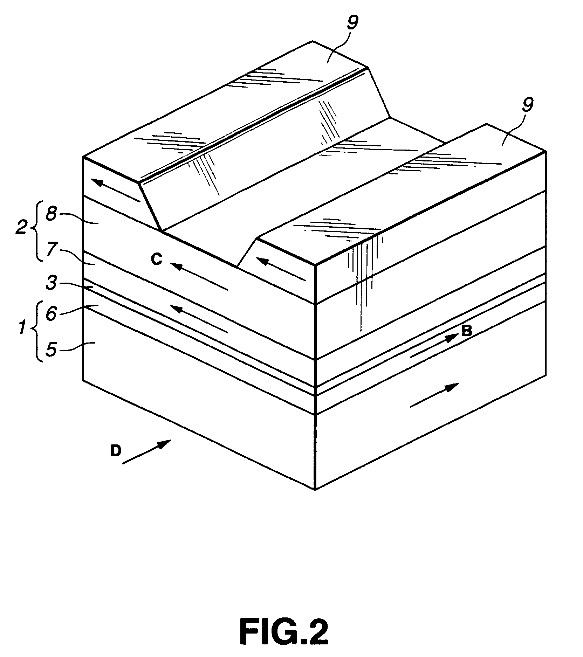

Fig. 2 shows an enlarged perspective view of the portion in the magnetic tunnel junction element where the first magnetic metal layer 1 and the second magnetic metal layer 2 are layered via the tunnel barrier layer 3.

In this magnetic tunnel junction element, the first magnetic metal layer 1 has a magnetization-fixed layer not changing its magnetization direction with respect to an external magnetic field. More specifically, the first magnetic metal layer 1 has a two-layered configuration having, for example, an IrMn film 5 and a CoFe film 6 successively layered from the side of the first electrode 4a.

In the first magnetic metal layer 1, the IrMn film 5 is made from an antiferromagnetic material and exchange coupling with the CoFe film 6 and fixes the magnetization of the CoFe film 6 in a predetermined direction. That is, in this magnetic tunnel junction element, the CoFe film 6 is a magnetization-fixed layer having a fixed magnetization in a predetermined direction.

On the other hand, the second magnetic metal layer 2 has a magnetization free layer changing its magnetization direction according to an external magnetic field. More specifically, the second magnetic metal layer 2 has a two-layered configuration of a CoFe film 7 and a NiFe film 8 which are successively layered from the side of the tunnel barrier layer 3.

In the second magnetic metal layer 2, the CoFe film 7 serves to increase the spin polarizability while the NiFe film 8 has a low coercive force and serves as a magnetization free layer changing its magnetization direction according to an external magnetic field. The second magnetic metal layer 2 having such a two-layered configuration can increase the magnetoresistance ratio of the magnetic tunnel junction element.

Moreover, in this magnetic tunnel junction element, the tunnel barrier layer 3 is formed from an insulation material such as Al₂O₃.

Moreover, as shown in Fig. 1 and Fig. 2, in the magnetic tunnel junction element, a non-conductive magnetic domain control film 9 is arranged at both end portions of the second magnetic metal layer 2.

The magnetic domain control film 9 is formed from a non-conductive antiferromagnetic material or a ferromagnetic material such as NiO. The NiO is a non-conductive oxide-system antiferromagnetic material and exchange coupling with the NiFe film 8 (magnetization free layer), performing a magnetic domain control of the NiFe film 8.

Moreover, in the magnetic tunnel junction element, a portion of the NiFe film 8 (magnetization free layer) sandwiched by the magnetic domain control films 9 serves as a magnet sensitive portion of the magnetic tunnel junction element.

This magnetic tunnel junction element is produced by a thin film formation step and the components constituting the magnetic tunnel junction element are successively layered on the basic material 10. That is, the magnetic tunnel junction element includes the first electrode 4a. the first magnetic metal layer 1, the tunnel barrier layer 3, and the second magnetic metal layer 2 which are successively layered on the basic material 10, and the magnetic domain control film 9 is formed at both end portions of the second magnetic metal layer 2, and the second electrode 4b is formed thereon.

More specifically, when producing the magnetic tunnel junction element, the basic material 10 includes, for example, an insulation layer of SiO₂, formed on a substrate 11 having smoothing surface made from Si.

Moreover, in the first metal magnetic layer 1, the IrMn film 5 is formed with a film thickness of about 10 nm and the CoFe film 6 is formed with a film thickness of about 5 nm. The IrMn film 5 and the CoFe film 6 are successively formed by sputtering or the like.

Moreover, the tunnel barrier layer 3 is formed by an Al₂O₃ film with a film thickness of about 1.3 nm. This Al₂O₃ film may be formed by forming an Al film on the CoFe film 6 by sputtering and oxidizing the film into Al₂O₃ using an oxygen plasma or the like, or by directly forming an Al₂O₃ film on the CoFe film 7 using the sputtering or the like. It should be noted that the tunnel barrier layer 3 is not to be limited to the Al₂O₃ film but may be made from any insulation material if it serves as a tunnel barrier of the so-called tunnel current, i.e., current flowing between the first magnetic metal layer 1 and the second magnetic metal layer 2.

Moreover, in the second magnetic metal layer 2, the CoFe film 7 is formed with a film thickness of about 5 nm while the NiFe film 8 is formed with a film thickness of about 20 nm. The CoFe film 7 and the NiFe film 8 are successively formed by sputtering or the like.

Moreover, the magnetic domain control film 9 is formed by a NiO film with a film thickness of about 50 nm. The magnetic domain control film 9 is not to be limited to the NiO film but may be formed from any non-conductive antiferromagnetic material or non-conductive hard magnetic material if it can perform the magnetic domain control of the NiFe film 8.

When producing the magnetic tunnel junction element, it is possible to successively form the IrMn film 5, the CoFe film 6 (magnetization-fixed layer), the Al₂O₃ film (tunnel barrier layer 3), the CoFe film 7, the NiFe film 8 (magnetization free layer), and the NiO film (magnetic domain control film 9) by sputtering or the like. These films can be successively formed with the same chamber without exposing the film materials to the atmosphere.

More specifically, firstly, the IrMn film 5, the CoFe film 6, the Al₂O₃ film, the CoFe film 7, the NiFe film, and the NiO film are successively formed in the same chamber by sputtering or the like.

Next, a resist material is applied onto the NiO film to form a resist film. This resist film is patterned into a predetermined pattern using the photolithography technique so as to obtain a resist pattern. The resist pattern is formed by patterning which leaves the resist film at portions other than the magnet sensitive portion of the magnetic tunnel junction element.

Next, this resist pattern is used as a mask when performing ion etching to remove the portion of the NiO film to serve as the magnet sensitive portion, so that the NiO film is formed at both end portions of the NiFe film 8.

Thus, when producing the magnetic tunnel junction element, it is possible to successively form the components of the magnetic tunnel junction element in a single chamber without exposing them to the atmosphere. Accordingly, the magnetic tunnel junction element can be prepared with a high accuracy.

In the magnetic tunnel junction element having the aforementioned configuration, when a predetermined voltage is applied between the first magnetic metal layer 1 and the second magnetic metal layer 2, a tunnel current flows via the tunnel barrier layer 3 in the direction indicated by arrow A in Fig. 1, i.e., in the direction from the second magnetic metal layer 2 to the first magnetic metal layer 1.

In this magnetic tunnel junction element, the CoFe film 6 of the first magnetic metal layer 1 serves as the magnetization-fixed layer not changing its magnetization direction while the NiFe film 8 of the second magnetic metal layer 2 serves as the magnetization free layer changing its magnetization direction according to an external magnetic field. For this, the CoFe film 6 (magnetization-fixed layer) is exchange coupling with the IrMn film 5 as the antiferromagnetic material and has a magnetization direction fixed in the direction indicated by arrow B in Fig. 2. On the other hand, the NiFe film 8 (magnetization free layer) is formed so as to have a uniaxial anisotropy in the direction indicated by arrow C in Fig. 2. Accordingly, when no external magnetic field is applied, the CoFe film 6 has a magnetization direction which approximately orthogonally intersects the magnetization direction of the NiFe film 8.

Moreover, the NiFe film 8 (magnetization free layer) is exchange coupling with the magnetic domain control film 9 (NiO film) formed thereon and has its magnetization direction fixed in the direction indicated by arrow C in Fig. 2. That is, the NiFe film 8 is controlled by the magnetic domain control film 9 formed at both end portions of the NiFe film 8, so that it has a single magnetic domain in the direction identical to the direction of the uniaxial anisotropy of the NiFe film 8. Accordingly, in this magnetic tunnel junction element, it is possible to suppress the Barkhausen noise generated by a discontinuous movement of a magnetic domain of the NiFe film 8 (magnetization free layer).

Moreover, in the NiFe film 8 (magnetization free layer), since the magnetic domain control film 9 (NiO film) has electrical no-conductance, the tunnel current flows only into the magnet sensitive portion sandwiched by the magnetic domain control films 9.

When an external magnetic field is applied to the magnetic tunnel junction element in the direction indicated by arrow D in Fig. 2, the magnetization direction of the NiFe film 8 (magnetization free layer) is changed to define a predetermined angle with the magnetization direction of the CoFe film 6 (magnetization-fixed layer). In this magnetization tunnel junction element, the resistance against the tunnel current changes depending on the relative angle between defined by the magnetization free layer and the magnetization-fixed layer. Accordingly, in this magnetic tunnel junction element, the external magnetic field change can be detected by measuring the resistance value change.

By the way, in this magnetic tunnel junction element, as has been described above, the magnetic domain control film 9 (NiO film) having non-conductance is arranged at both end portions of the NiFe film 8 (magnetization free layer) so that the magnetic domain control of the NiFe film 8 is performed by the magnetic domain control films 9.

Thus, in the magnetic tunnel junction element, there is no danger of electrical short circuit and the current can be made to flow only in the magnet sensitive portion of the NiFe film 8 (magnetization free layer). Accordingly, it is possible to suppress the Barkhausen noise generated by a discontinuous movement of a magnetic domain of the NiFe film 8 and to obtain a preferable characteristic.

Next, explanation will be given on the tunneling magnetoresistive head (hereinafter, referred to as a TMR head) according to the present invention.

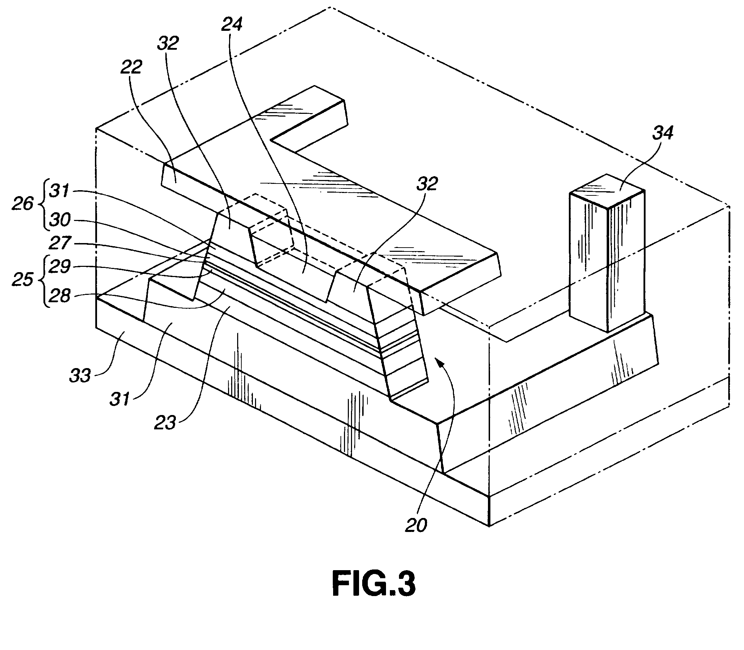

As shown in Fig. 3, this TMR head includes a magnetic tunnel junction element 20 sandwiched by a lower shield layer 21 and an upper shield layer 22 via a lower gap layer 23 and an upper gap layer 24.

In this TMR head, the magnetic tunnel junction element 20 is the aforementioned magnetic tunnel junction element according to the present invention applied to a magnetic head and includes a first magnetic metal layer 25 and a second magnetic metal layer 26 which are layered via a tunnel barrier layer 27.

In this magnetic tunnel junction element 20, the first magnetic metal layer 25 has a magnetization-fixed layer which does not change its magnetization direction with respect to an external magnetic field. More specifically, the first magnetic metal layer 25, for example, has a two-layered configuration including an IrMn film 28 and a CoFe film 29 which are successively layered from the side of the lower gap layer 23.

In the first magnetic metal layer 25, the IrMn film 28 is an antiferromagnetic material and exchange coupling with the CoFe film 29, so that the magnetization direction of the CoFe film 29 is fixed in a predetermined direction. That is, in this magnetic tunnel junction element 20, the CoFe film 29 serves as a magnetization-fixed layer having a fixed magnetization in a predetermined direction.

On the other hand, the second magnetic metal layer 26 has a magnetization free layer which changes its magnetization direction according to an external magnetic field. More specifically, the second magnetic metal layer 26, for example, has a two-layered configuration including a CoFe film 30 and a NiFe film 31 which are successively layered from the side of the tunnel barrier layer 27.

In the second magnetic metal layer 26, the CoFe film 30 is used to increase the spin polarizability while the NiFe film 31 has a low coercive force and serves as a magnetization free layer changing its magnetization direction according to an external magnetic field. The second magnetic metal layer 26 having such a two-layered configuration can increase the magnetic resistance ratio of the magnetic tunnel junction element 20.

Moreover, in the magnetic tunnel junction element 20, the tunnel barrier layer 27 is formed, for example, from an insulation material such as Al₂O₃.

Moreover, the magnetic tunnel junction element 20 includes a non-conducting magnetic domain control film 32 arranged at both end portions of the medium facing sides on the NiFe film 31 (magnetization free layer). This magnetic domain control film 32 is made from a non-conducting antiferromagnetic material or ferromagnetic material such as NiO. The NiO is a non-conducting oxide-system antiferromagnetic material exchange coupling with the NiFe film 31 and performs a magnetic domain control of the NiFe film 31.

It should be noted that in this TMR head, one end surface exposed externally is the medium facing surface to face a magnetic recording medium and the portion sandwiched by the NiFe film 31 and the magnetic domain control film 32 in the magnetic tunnel junction element 20 serves as a magnet sensitive portion of the magnetic tunnel junction element 20.

Moreover, in the TMR head, the upper shield layer 22 and the lower shield layer 21 are made from a magnetic material having electric conductivity. Moreover, the upper gap layer 24 and the lower gap layer 23 is made from a non-magnetic material having electric conductivity.

Thus, in the TMR head, the first magnetic metal layer 25 is magnetically isolated from the lower shield layer 21, and the second magnetic metal layer 26 is also magnetically isolated from the upper shield layer 22.

Moreover, in the TMR head, since the lower shield layer 21, the lower gap layer 23, the upper gap layer 24, and the upper shield layer 22 are made from a material having electric conductivity, the lower shield layer 21 and the lower gap layer 23 serve as an electrode with respect to the first magnetic metal layer 25 while the upper shield layer 22 and the upper gap layer 24 serve as an electrode with respect to the second magnetic metal layer 26.

By the way, the TMR head is produced by a thin film formation step which will be detailed later and the components constituting this TMR head are successively layered on the substrate 33.

Moreover, this TMR head includes an insulation material filled in a space defined between the substrate 33 and the upper shield layer 22. More specifically, in the TMR head, the lower gap layer 23, the magnetic tunnel junction element 20, the magnetic domain control film 32, and the upper gap layer 24 are formed so as to be buried in the insulation material. Moreover, on the end portion of the lower shield layer 21, there is arranged a connection terminal 34 formed from a conductive material and having a height reaching the upper shield layer 22.

It should be noted that the insulation material filled in the TMR head is omitted in the figure.

When the TMR head having the aforementioned configuration is subjected to a signal magnetic field from a magnetic recording medium, the magnetization direction of the NiFe film 31 (magnetization free layer) changes with respect to the CoFe film 29 (magnetization-fixed layer) having a magnetic domain fixed in a predetermined direction.

Here, a predetermined voltage is applied between the lower shield layer 21 and the upper shield layer 22 and a tunnel current is flowing from the second magnetic metal layer 26 to the first magnetic metal layer 25 via the tunnel barrier layer 27. In the TMR head, when the magnetization direction of the NiFe film 31 (magnetization free layer) is changed to change a relative angle with respect to the magnetization direction of the CoFe film 29 (magnetization-fixed layer), the resistance value with respect to the tunnel current is changed. Thus, in the TMR head, it is possible to detect a signal magnetic field from the magnetic recording medium.

By the way, in the TMR head, the non-conducting magnetic domain control film 32 is arranged at both end portions of the medium facing side on the NiFe film 31 (magnetization free layer) and this magnetic domain control film 32 performs the magnetic domain control of the NiFe film 31.

Thus, in this TMR head, electric current can flow only in the magnet sensitive portion of the NiFe film 8 (magnetization free layer) without causing an electric short circuit. Accordingly, it is possible to suppress the Barkhausen noise generated by a discontinuous movement of a magnetic domain of the NiFe film 8 and stabilize the reproduction output.

Next, explanation will be given on a specific production method of the aforementioned TMR head.

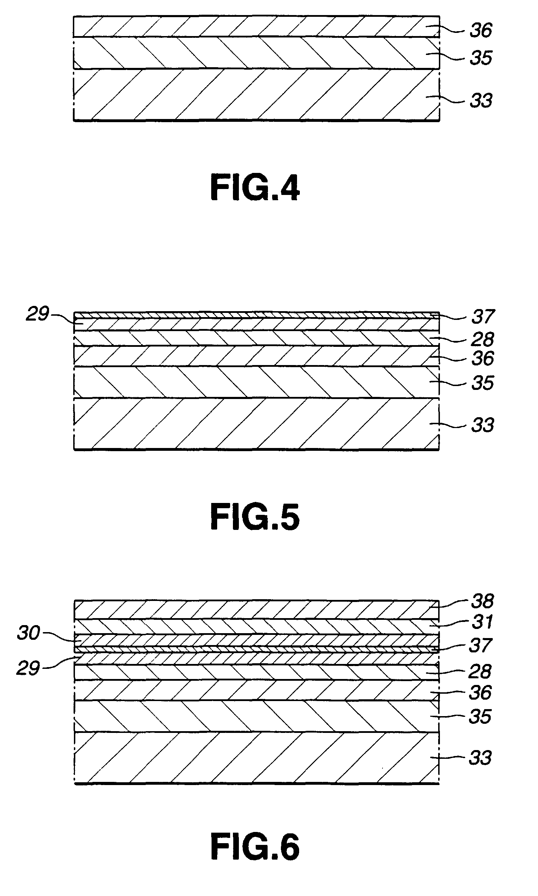

When producing the TMR head, firstly, as shown in Fig. 4, an AlTiC-system or TiO-CaO-system substrate 33 is prepared as such that is usually used for producing a thin film type magnetic head. On one main surface of this substrate 33, a magnetic metal film 35 is formed from sendust or the like to serve as the lower shield layer 21 and then a non-magnetic metal film 36 is formed from Ta or the like to serve as the lower gap layer 23. Here, the non-magnetic metal film 36 is used as the undercoat layer of the magnetic tunnel junction element 20 and preferably has a highly flattened surface.

Next, as shown in Fig. 5, on the non-magnetic metal film 36, an IrMn film 28 and a CoFe film 29 are successively formed to serve as the first magnetic metal layer 25. Moreover, the IrMn film 28 is subjected to an orientation processing so that it is exchange coupling with the CoFe film 29 in an approximately parallel direction with respect to a signal magnetic field applied from a magnetic recording medium.

On the CoFe film 29, a Al₂O₃ film 37 is formed to serve as the tunnel barrier layer 27. This Al₂O₃ film 37 is formed by forming an Al film on the CoFe film 29 and then oxidizing the Al film by oxygen plasma. In this case, the Al₂O₃ film 37 is controlled in oxidization by adjusting, for example, the oxidization time, the gas pressure, the oxygen partial pressure, the high frequency power, and the like. Moreover, the Al₂O₃ film 37 may be formed by directly forming the Al₂O₃ film on the CoFe film by sputtering.

Next, as shown in Fig. 6, on the Al₂O₃ film 37, a CoFe film 30 and a NiFe film 31 are successively formed to serve as the second magnetic metal layer 26. Moreover, the CoFe film 30 and the NiFe film 31 are subjected to an orientation processing so as to have a uniaxial anisotropy in a direction approximately vertical to a signal magnetic field applied from a magnetic recording medium.

On the NiFe film 31, an NiO film 38 is formed to serve as the magnetic domain control film 32. The NiO film 38 is subjected to an orientation processing so as to be exchange coupling with the NiFe film 31 in a direction approximately vertical to a signal magnetic field applied from a magnetic recording medium.

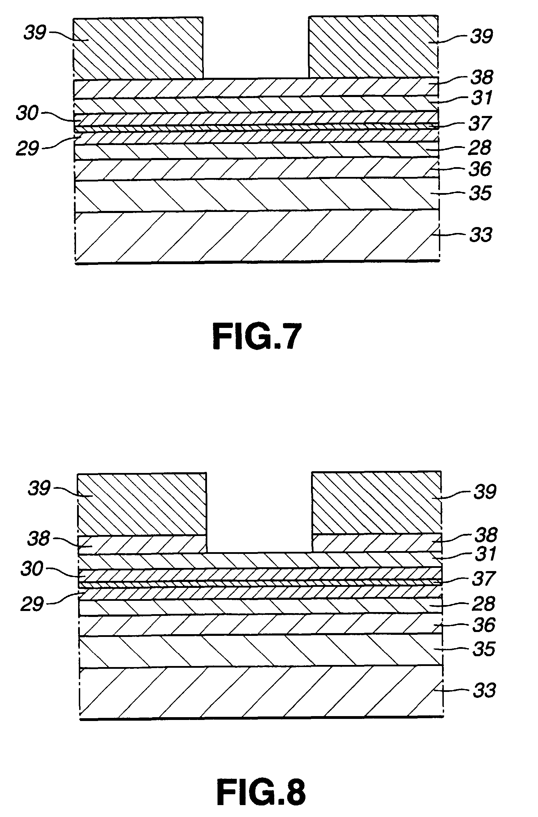

Next, as shown in Fig. 7, a resist material is applied onto the NiO film 38 to form a resist film, which is patterned into a predetermined configuration using the photolithographic technique, so as to obtain a resist pattern 39. More specifically, the resist pattern 39 is formed by such a patterning that the resist film remains on a region other than the portion to become the magnet sensitive portion on the NiFe film 31.

Next, as shown in Fig. 8, using this resist pattern 39 as a mask, the NiO film 38 if the region not having the resist pattern 39 is etched and removed by the ion milling method or the like until the NiFe film 31 formed thereunder is exposed. Thus, the NiO film 38 and the resist pattern 39 remain on the region outside the magnet sensitive portion on the NiFe film 31.

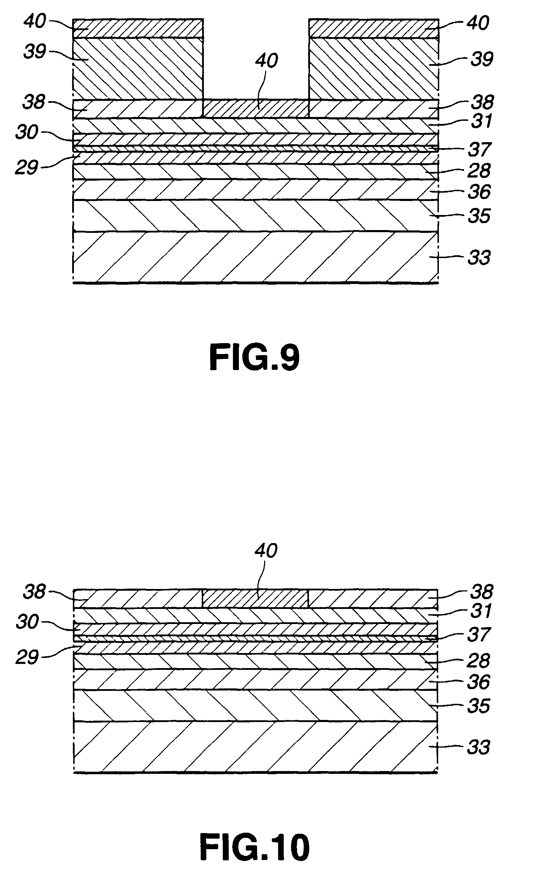

Next, as shown in Fig. 9, with the resist pattern 39 remaining, a non-magnetic metal film 40 such as Ta is formed by sputtering so as to serve as the upper gap layer 24.

Next, as shown in Fig. 10, together with the resist pattern 39, the non-magnetic metal film 40 remaining on the resist pattern 39 is peeled off and removed using an organic solvent or the like. Thus, the upper gap layer 24 is formed on the region to serve as the magnet sensitive portion on the NiFe film 31.

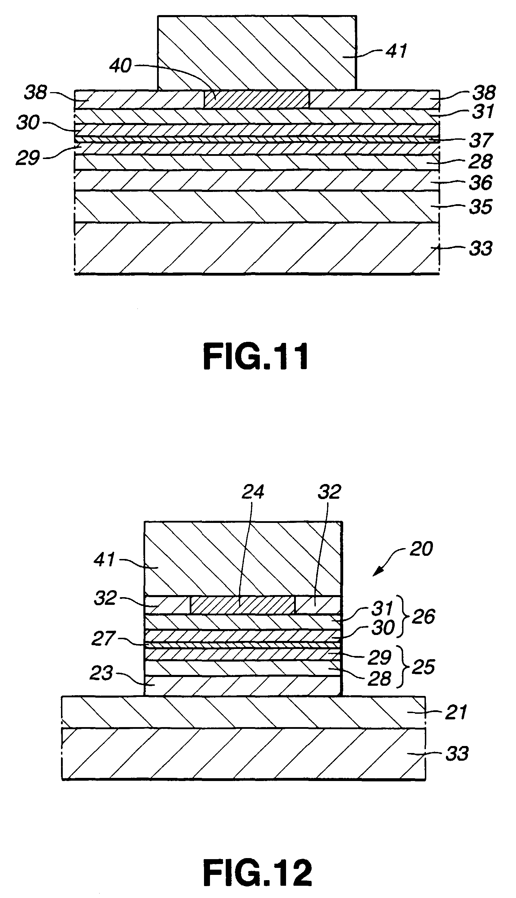

Next, as shown in Fig. 11, a resist material is applied onto the upper gap layer 24 and the NiO film 38 so as to form a resist film, which is patterned into a predetermined configuration using the photolithographic technique so as to obtain a resist pattern 41. More specifically, the resist pattern 41 is formed by such a patterning that the resist pattern 41 remains on the region to become the magnetic tunnel junction element 20.

Next, as shown in Fig. 12, using this resist pattern 41 as a mask, the portion not having the resist pattern 41 is etched and removed by the ion milling method or the like until the magnetic metal film 35 formed thereunder is exposed to serve as the lower shield layer 21. Thus, on the lower shield layer 21, the lower gap layer 23 having a predetermined configuration, the first magnetic metal layer 25, the tunnel barrier layer 27, the second magnetic metal layer 26, the magnetic domain control film 32, and the upper gap layer 24 are formed. That is, the magnetic tunnel junction element 20 having a predetermined configuration defined by the resist pattern 41.

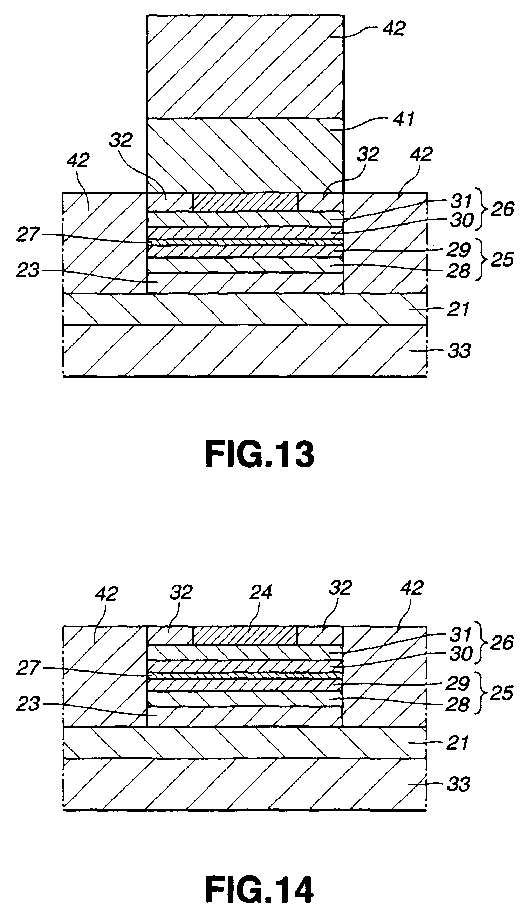

Next, as shown in Fig. 13, with the resist pattern 41 remaining, an insulation film 42 is formed by sputtering or the like so as to have almost identical height as the boundary between the resist pattern 41 and the magnetic domain control film 32 and the upper gap layer 24.

Next, as shown in Fig. 14, the insulation film 42 remaining on the resist pattern 41 is peeled off and removed together with the resist pattern 41 using an organic solvent or the like. Thus, the magnetic tunnel junction element 20 is arranged as being buried in the insulation film 42.

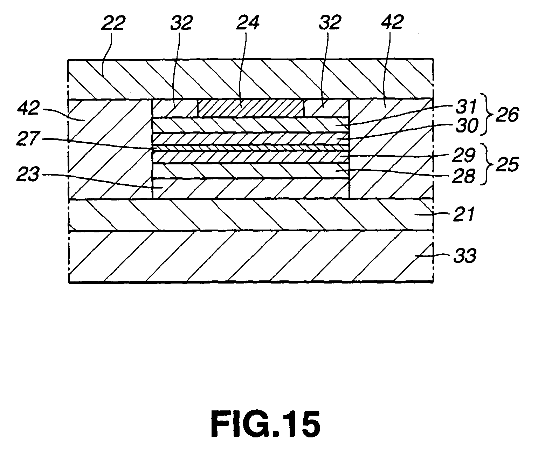

Next, as shown in Fig. 15, on the main surface from which the resist pattern 41 has been removed, the upper shield layer 22 having a predetermined configuration is formed. The upper shield layer 22 may be formed by plating using a resist pattern having a predetermined configuration applied to the magnetic metal film to become the upper shield layer 22, or forming the magnetic metal film to become the upper shield layer 22 by sputtering and then etching it into a predetermined configuration.

Photolithography and etching are used to form the insulation film 42 and the lower shield layer 21 into a predetermined configuration. Moreover, an opening is formed in the insulation film 42 on the end portion of the lower shield layer 21, so as to expose the lower shield layer 21. This opening is filled with a conducting material and a connection terminal 34 is formed on the lower shield layer 21. Thus, the lower shield layer 21 can be electrically connected together with the upper shield layer 22.

As has been described above, the tunneling magnetoresistive head as shown in Fig. 3 is prepared.

According to this method, it is possible to successively perform the film formation process of the components constituting the TMR head, the etching process, or the Al film oxidization process in a single chamber without exposing the components to the atmosphere. Accordingly, it is possible to produce the TMR head with a high accuracy.

As has been described above, the magnetic tunnel junction element according to the present invention having the non-conducting magnetic domain control film formed at both end portions of the medium facing side of the second magnetic layer can suppress generation of the Barkhausen noise without causing an electric short circuit and obtain a preferable characteristic.

Moreover, according to the magnetic tunnel junction element production method according to the present invention, the components of the magnetic tunnel junction element can be successively formed in a single apparatus without exposing them to the atmosphere, thereby enabling to prepare the magnetic tunnel junction element with a high accuracy.

Moreover, in the tunneling magnetoresistive head according to the present invention, the non-conducting magnetic domain control film is formed at both end portions of the medium facing side of the second magnetic layer of the magnetic tunnel junction element and accordingly, no electric short circuit is generated. Thus, it is possible to suppress generation of the Barkhausen noise and stabilize the reproduction output.

Moreover, according to the tunneling magnetoresistive head production method according to the present invention, it is possible to successively form the components of the tunneling magnetoresistive head in a single apparatus without exposing the components to the atmosphere. Thus, it is possible to prepare the tunneling magnetoresistive head with a high accuracy.

## Claims

1. A magnetic tunnel junction element comprising:
a first magnetic layer having magnetization fixed in a predetermined direction,
an insulation layer formed on said first magnetic layer, and
a second magnetic layer formed on said insulation layer and changing its magnetization direction according to an external magnetic field,
wherein said second magnetic layer is provided with non-conducting magnetic domain control films formed at both end portions on said second magnetic layer.

2. The magnetic tunnel junction element as claimed in Claim 1, wherein said magnetic domain control film is made from an oxide-system antiferromagnetic material.

3. A magnetic tunnel junction element production method comprising steps of:
forming a first magnetic layer having its magnetization direction fixed in a predetermined direction,
forming an insulation layer on said first magnetic layer,
forming a second magnetic layer on said insulation layer so as to change its magnetization direction according to an external magnetic field,
forming a non-conducting magnetic domain control film on said second magnetic layer,
forming a resist pattern having a predetermined configuration on said magnetic domain control film, and
removing said magnetic domain control film by etching using said resist pattern excluding the both end portions on said second magnetic layer.

4. The magnetic tunnel junction element production method as claimed in Claim 3, wherein said magnetic domain control film is formed using an oxide-system antiferromagnetic material.

5. A tunneling magnetoresistive head comprising a first magnetic layer having magnetization fixed in a predetermined direction, an insulation layer formed on said first magnetic layer, a second magnetic layer formed on said insulation layer and changing its magnetization direction according to an external magnetic field,
wherein said second magnetic layer is provided with non-conducting magnetic domain control films on both end portions thereof.

6. The tunneling magnetoresistive head as claimed in Claim 5, wherein said magnetic domain control film is made from an oxide-system antiferromagnetic material.

7. A tunneling magnetoresistive head production method in which a magnetic tunnel junction element is produced by steps of:
forming a first magnetic layer having its magnetization direction fixed in a predetermined direction,
forming an insulation layer on said first magnetic layer,
forming a second magnetic layer on said insulation layer so as to change its magnetization direction according to an external magnetic field,
forming a non-conducting magnetic domain control film on said second magnetic layer,
forming a resist pattern having a predetermined configuration on said magnetic domain control film, and
removing said magnetic domain control film by etching using said resist pattern excluding the both end portions on said second magnetic layer.

8. The tunneling magnetoresistive head production method as claimed in Claim 7 wherein said magnetic domain control film is formed using an oxide-system antiferromagnetic material.
